# EUROPEAN PATENT SPECIFICATION

(11) **EP 3 153 411 B1**
(45) Date of publication and mention of the grant of the patent: **05.08.2020**
(21) Application number: 15188564.7
(22) Date of filing: 06.10.2015
(51) Int. Cl.: H01T 4/12, H05B 47/24, H05B 47/25, H05B 45/50

(54) **SURGE ARRESTER OF AN AIRFIELD LIGHTING SYSTEM AND A SECONDARY CIRCUIT OF AN AIRFIELD LIGHTING SYSTEM**
ÜBERSPANNUNGSABLEITER EINES FLUGPLATZBELEUCHTUNGSSYSTEMS UND EINE SEKUNDÄRSCHALTUNG SCHALTUNG EINES FLUGPLATZBELEUCHTUNGSSYSTEMS
LIMITEUR DE SURTENSION D'UN SYSTÈME D'ÉCLAIRAGE DE TERRAIN D'AVIATION ET CIRCUIT SECONDAIRE D'UN SYSTÈME D'ÉCLAIRAGE DE TERRAIN D'AVIATION

(43) Date of publication of application: 12.04.2017
(73) Proprietor: Efla Oy, 06150 Porvoo (FI)
(72) Inventor: Laukkanen, Mika, 06150 Porvoo (FI); Einovaara, Jaakko, 06150 Porvoo (FI)
(74) Representative: Papula Oy

(56) References cited:
- EP-A2- 1 995 837
- EP-A2- 2 579 690
- WO-A1-94/02919
- WO-A1-2013/008152
- US-A1- 2008 001 782
- "RS-485 Port Protection Evaluation Board", , 31 October 2012 (2012-10-31), pages 1-2, XP055257661, Retrieved from the Internet: URL:http://www.bourns.com/docs/Products-Ge neral/rs-485-port-protection-evaluation-bo ard-1.pdf?sfvrsn=6 [retrieved on 2016-03-11]
- "Electrical installations for lighting and beaconing of aerodromes - Characteristics of inset and elevated luminaires used on aerodromes and heliports", IEC TS 61827:2004, IEC, 3, RUE DE VAREMBÉ, PO BOX 131, CH-1211 GENEVA 20, SWITZERLAND, 14 May 2004 (2004-05-14), pages 1-25, XP082003991, [retrieved on 2004-05-14]

## Description

### FIELD OF THE INVENTION

The invention relates to airfield lighting systems, and particularly to overvoltage protection of airfield lighting systems.

### BACKGROUND

One important aspect of operation of an airfield or an airport is proper operation of the airfield lighting system or aeronautical ground lighting (AGL). Such lighting system includes approach and threshold lighting, run-way lighting and taxiway lighting, for example.

The various components used in lighting are operated in extremely harsh conditions, as the temperatures in the open airfields vary considerably and various chemicals are used in the operation and maintenance of the planes and the airfield. Therefore strict requirements are set to the components of the lighting system. The components are usually installed in pits or cans, but they can be also buried directly into the ground. In normal operation they must be totally resistant for water, ice, kerosene, anti-freeze and defrosting liquids, etc. at operational voltages up to 5kV.

The housing of the components must also be resilient enough to work as shock-absorber and protect the various components. Airports usually expect the life span of transformers and connectors to be 10-20 years in these very demanding circumstances.

In airfield lighting systems, there are two types of feed for lighting fixtures located along a runway or a taxiway: series feed and parallel feed. With the parallel feed a progressive voltage drop occurs from light to light even with bigger cable dimensions. This causes the light illumination levels to vary. For this reason series feed systems are more common in the airfield lighting.

A series circuit fed circuit utilizes a constant current regulator, insulating transformers and lamps specially designed for a rated current. In a series circuit current is fed to a current loop which has primary windings of the insulating transformers connected in series. The secondary windings of the insulating transformers provide a set current to the illumination device. The nominal current in the series feed system circuits is most commonly 6.6 Amperes, but the current may vary.

The primary circuit is supplied by a constant current regulator (CCR) which makes it possible to obtain the rated light intensity of 6.6A fixtures. The brightness of the lights is controlled by reducing the current usually by 5 different steps. The series circuit, which is thus known as the primary circuit, consists of a single-core cable connecting the separation transformers in series.

The transformers have a twofold function. Firstly, the transformers protect the personal by insulating the secondary circuit from the high voltage of the primary circuit. Secondly, the transformers enable to maintain continuity of the primary circuit when a light in the secondary is out of service. Thus the primary current flows to all the transformers enabling the operation of the in-tact lights.

The secondary of each insulating transformer is normally connected to a single light by means of a secondary two-core cable or 2 one-core wires. It is also possible to supply several lights with a single transformer when the lights are close to one another. The lamps used in the installations may be, for example halogen, cascade tubes or LED's.

The insulating transformers are furnished with 2 primary cables and one secondary cable with molded-on connectors. Transformers can be buried near the light but it is preferable for them to be placed housed in an inspection man-holes.

The primary cable, furnished with field-assembled connectors, is connected in segments from one transformer to the next in the same circuit until the circuit forms a loop with outgoing and incoming cables connected to the constant current regulator. The primary cable is typically buried in a trench joining inspection man-holes, between two layers of sand, out of reach of stones or any objects which could damage it.

Although more costly, the use of a cable with a shield is strongly recommended in countries with frequent storms. An unshielded cable must normally be protected from the effects of the weather by means of a bare equipotential earth wire located about 10 cm above it in the trench.

The shield and equipotential wire are connected with the regulator earth connection. On the cables with a shield, the shield is insulated by the protective sheath, and should be connected with earth rods about every 300 m.

The inspection man-holes can be made of welded steel or prefabricated concrete. The latter system is preferable as all corrosion risks are excluded. They should be covered with a steel or reinforced concrete plate. Provision should be made for drainage.

In some cases of runway inset lights, the transformer and the secondary circuit structure are placed under the light itself in a fixture commonly known as a "can". This solution presents the inconvenience of running the high voltage primary cables under the runway, thus giving significant difficulties of repair in case of failure on those cables. The light installation fixture geometries are standardized and the space under the light is quite small. This limits the maximum size of components that can be connected to the secondary circuit. The installation space in pits and especially in cans is very limited, which makes certain requirements for the physical size of the products.

The secondary cable lead, which consists of cable with usually field-assembled plug and receptacle, or a prefabricated with molded-on connecting parts, connects the light to the transformer by means of a sealed plug. This connection, running along a trench, in a wireway in the pavement or in a conduit tube, can be made by means of a bipolar cable or two segments of unipolar cable joined on the transformer side, to a KIT plug. These secondary equipment are 1 kV isolated according to requirements given in FAA 150-5345-26D.

Certain climate regions have thunder and lightning more often than other regions. It is known to have surge arresters providing lightning protection in the primary circuit. Such units must withstand the high voltages (up to 5000 V) of the primary circuit which makes the units large in size and quite expensive. The large size prevents the units to be installed in fixtures under the light. If the unit is made inoperable for example by a direct lightning strike the cost of replacing the unit is quite high and also the whole circuit, in the worst case consisting of over 200 AGL-fittings, must be turned off during this operation.

FAA regulations demand that the lights are protected from surge currents. In case of inducted overvoltage the lights should be protected by it's build in surge protection as defined in FAA Engineering Brief No. 67 (Nominal discharge current 8/20pS of 5kA).

Due to electrical efficiency and controllability LED's are more and more used as illumination sources in airfield installations. LED light sources require additional circuitry in the secondary circuit and thereby the costs relating to illumination have risen. Further, some diagnostic features including communication and data transmission can be provided in the secondary circuit.

One of the problems associated with the above arrangement is that the protection provided by the installations against surge voltages is some-what limited. The costs of operation and maintenance of the system increase when the described protection is used in climate condition in which lightning rate is high. The amount of additional circuitry in the secondary circuit adds the maintenance costs if the surge protection is not capable of limiting the voltages and currents efficiently. Further, the mentioned operation downtime is costly as the airports or runways may be closed.

Publications US 2008/001782 A1, EP 2579690 A2, and WO 94/02919 A1 disclose information that may be regarded as useful for understanding the background. Airfield lightning system is described having a lightning protection device protecting the lightning fixture from the power surge produced by lightning strikes.

### BRIEF DESCRIPTION OF THE INVENTION

This summary is provided to introduce a selection of concepts in a simplified form that are further described below in the detailed description. This summary is not intended to identify key features or essential features of the claimed subject matter, nor is it intended to be used to limit the scope of the claimed subject matter.

An object of the present invention is to provide surge arrester and a secondary circuit so as to alleviate the above disadvantages. The objects of the invention are achieved by a circuit which is characterized by what is stated in the independent claim. The preferred embodiments of the invention are disclosed in the dependent claims.

The invention is based on the idea of providing a hermetically sealed surge arrester with connectors to be installed to the secondary circuit of an airfield lighting installation.

An advantage of the circuit of the invention is that the protection provided by the circuit is more efficient in protecting the lighting installations than the known systems. In the known systems, when a surge voltage is applied to the light source or lighting fixture located at the airfield, the surge voltage can spread to the primary circuit and to other lighting fixtures located at the proximity of the source of the surge voltage. With the present invention, however, the current originated from a surge voltage is led to the ground at the secondary side of the lighting installation such that the high currents are not causing any substantial damage in other installed lighting fixtures. The known surge arresters of the lighting fixtures are provided as integral parts of the lighting fixtures to protect the lighting fixtures themselves.

The surge arrester of the invention enables to protect the primary circuit and the neighbouring secondary circuits from a lightning strike that hits a lighting fixture. If a lightning strikes to an illumination device of a secondary side, a high current flows through the isolation transformer to the primary circuit. If the primary circuit is seriously damaged, the constant current regulator may not be able to provide desired current to the primary circuit, and thereby whole illumination system will be out of order.

As the voltage of the secondary circuit of the lighting system is considerably lower than in the primary circuit, the surge arrester can be made smaller than the ones used in the primary circuit. The smaller size enables to position the surge arresters in close proximity to the light sources and other circuitry relating to the light sources. The surge arresters of the invention can be placed to the cans or pits together with the lighting fixtures.

With the surge arrester of the invention, especially the protection of the light sources and the circuitry relating to the light sources is increased. Modern air field lighting systems are employing LED's as light sources in the illumination due to the advantages obtained with LED technology. LED light sources and the required circuitry are quite expensive when compared to traditional incandescent halogen lights, for example. Further, the secondary circuit may also include electronic circuits that are used for monitoring or control-ling of the operation of the light source. The secondary circuit with the surge arrester protects also the other components and the circuitry than the light source. The secondary circuit of the invention thus provides a cost efficient protection for the installed components as installation space of the surge arresters is smaller than with the known primary side surge arresters. Further, the increased protection decreases the maintenance costs as the costly light sources and related circuitry are kept in proper operation for longer periods.

As the surge arrester of the invention is a small-sized stand-alone passive unit, it can be installed to existing lighting installations. The surge arrester provides a straight current path through the component when voltages of the secondary circuit are in allowable range. This means that all the signals and electrical power can pass through the surge arrester without any modifications to the waveform. Further, as the surge arrester of the invention comprises connectors, the device can be easily attached to existing installations.

### BRIEF DESCRIPTION OF THE DRAWINGS

In the following the invention will be described in greater detail by means of preferred embodiments with reference to the accompanying drawings, in which
Figure 1 is shows a simplified circuit diagram of an airfield lighting system with series feed;
Figures 2 and 3 shows examples of secondary circuits with the surge arrester; and
Figure 4 shows an example of a surge arrester circuit.

### DETAILED DESCRIPTION OF THE INVENTION

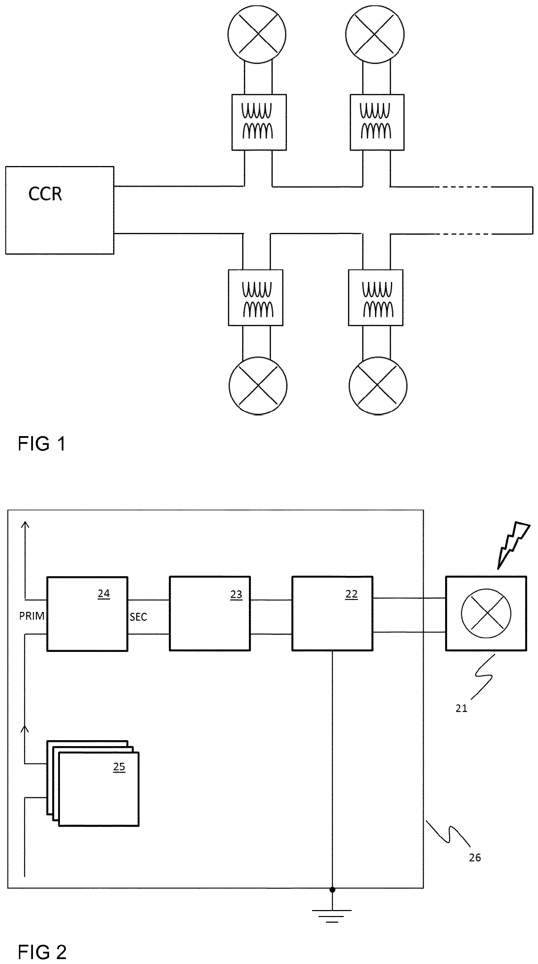

Figure 1 is shows a circuit of the type used commonly in airfield lighting system. A constant current regulator feeds constant current to a loop which is formed of series connection of primary windings of separation transformers and cabling connecting the transformers. The constant current regulator adjusts its output voltage such that desired current will flow via the primary circuits of the transformers. The secondary windings of the transformers provide power to secondary circuits which are equipped with light sources or illumination devices, such as LED's.

According to the present invention, the surge arrester comprises a hermetically sealed enclosure for protecting the circuitry of the surge arrester and connectors for electrically connecting the surge arrester to the secondary circuit. The surge arrester is adapted to provide a low impedance current path to ground for excessive voltages. The surge arrester of the invention is connectable with the provided connectors electrically to the illumination device for providing a low impedance path to ground from the secondary circuit for excessive voltages.

As shown in Figure 2 a surge arrester of the invention 22 is connected to the electric conductors or feed wires feeding the light source 21. In operation within normal operation voltages of the system, the surge arrester 22 does not affect the power feed to the light source 21 and provides thus a path for all the signals entering the secondary circuit. That is to say that a zero impedance current path is provided in the secondary circuit for the power feed to the light source by the surge arrester in normal operation of the secondary circuit.

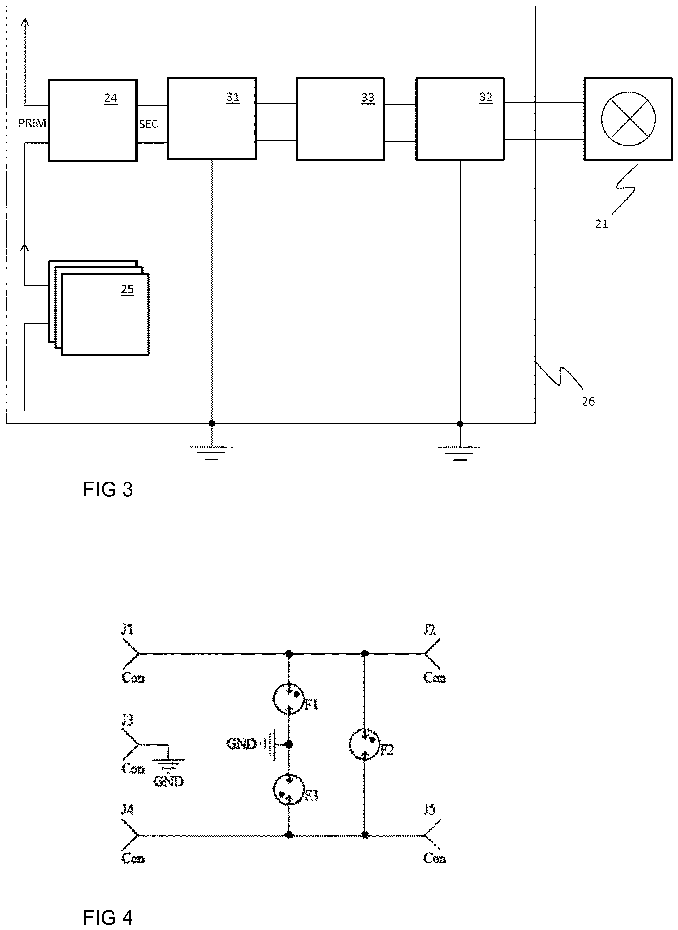

Figure 4 shows an embodiment of a surge arrester that is suitable for use in the secondary circuit of the airfield lighting system. The circuit employs three gas discharge tubes (GDT) F1, F2, F3 or similar components that change from high impedance state to low impedance state depending on the voltage over the component. Two of the three GDT's are connected in series between the operational power feed conductors and the center point between the series connection is connectable to ground. One of the protective components is connected directly between the power feed conductors. When excessive voltage is build across the power feed conductors, the impedance of the protective components drops, and current is led to ground.

Figure 2 also shows a single lamp control module (SLCM) 23 connected at the input of the secondary circuit, that is, at the output of the secondary winding. Single lamp control module 23 is a device that may control the light source in desired manner and monitor the operation condition of the light source 21. SLCM may include electronic circuits that are arranged to detect information coded to the supplied voltage or current. Further, SLCM may also transmit information relating to the operation of the light source to centralized control system.

Figure 2 shows also other transformers 25 connected to the primary circuit. It is clear, that the other transformers may also include secondary circuits that are similar to that described in more detail. In Figure 2 a lighting stroke is shown to hit the light source 21. In such situation, a high current flows through the light source and partial current flows via the conductor to-wards the surge arrester 22. When the voltage in the surge arrester increases, the impedance of the surge arrester drops dramatically and the current is led through the surge arrester to ground. In Figure 2 the installations are shown to be situated in a cable pit which is grounded, and the surge arrester is connected to ground by connecting the grounding terminal of the surge arrester to the cable pit.

Although the light source will probably be destroyed by the direct lighting strike, the surge arrester will protect other components in the secondary circuit. In addition to protecting the secondary circuit, the surge arrester protects also the isolation transformer, primary circuit and other secondary circuits. Thus the surge arrester operates to protect the power feed whereas typical surge arrester installations are protecting single loads.

When lightning strikes near to an installation of the secondary circuit, overvoltages will be induced to the wires of the secondary circuit. Similarly as in the Figure 2, the surge arrester of the invention will operate to short-circuit the current to the ground and thereby alleviate the influences of the overvoltage.

Figure 3 shows a secondary circuit with two surge arresters 31, 32 of the invention. The surge arresters are shown to be installed on both sides of the single lamp control module 33 in the secondary circuit of an airfield lighting installation. When using two surge arresters as shown, the protection of the installation is further increased. The surge arrester 31 connected at the input of the secondary circuit helps in minimizing the voltages or currents arriving from the primary side. In case a surge current enters the secondary side of the transformer due to abnormal voltage in the primary side of the transformer, the surge arrester connected at the input of the secondary circuit blocks the over voltage and thereby protects the single lamp control module 33 or any other installation in the secondary circuit. If the high current or volt-age still proceeds towards the light source, the second surge arrester 32 will operate to protect the light source installation.

The installation of Figure 3 increases the protection also in cases when surge voltage is applied to the light source or to the circuitry of the light source. The surge arrester 32 installed between the single lamp control module 33 and the light source protects the installation as in the example of Figure 2. The other surge arrester 31 adds protection by further protecting the transformer and the primary circuit of the transformer by shorting voltages that could still harm the primary circuit and the transformer.

As mentioned, the surge arrester of the invention comprises connectors with which the surge arrester can be installed to the secondary circuit. The connectors are preferably in a form of standardized connectors enabling to attach the surge arrester to standard installations.

According to the invention, the surge protector is hermetically sealed. The hermetic sealing means in practice that the surge protector of the invention is fabricated to withstand the airfield environment including wide range of temperatures and different chemicals. According to an embodiment, the hermetically sealed structure comprises low pressure molded inner structure which encloses the circuitry in a printed circuit board. The structure further comprises an outer surface producing the hermetically sealed casing for the circuit. The low pressure molded inner structure provides mechanical strength against mechanical forces and vibrations for the physical device while the outer surface provides the hermetic sealing of the device.

The surge protector of an embodiment may be provided without wires extending from the casing of the device. In such a case the connectors are directly attached to the circuit board or wired to the circuit board inside the protective casing. The connectors typically consist of a male and a female connectors and an earthing connector which can be wired to a grounded spot during installation of the device.

The connectors or interfaces are also manufactured in fully water-tight manner such that when connected to mating connectors, the outer material of the enclosure of the surge protector extends over the point of connection. The connectors enable to connect the surge protector to a light source, possible single light control module or other similar electronic device, the secondary of the transformer or to another similar surge protector.

The surge protector of an embodiment build using gas discharge tubes can withstand multiple instances of surge voltages. In a direct lightning hit to an illumination device the amount of energy is capable of destroying the illumination device although some of the current is led directly to ground using earth termination of the lamp. In case the surge protector is also destroyed by a surge voltage, the surge protector has operated to limit the influence of the surge voltage. As the surge protector of the invention is situated in the secondary circuit, the device can be safely changed to a new one without interrupting the operation of other light sources.

It will be obvious to a person skilled in the art that the embodiments can be implemented in various ways. The invention and its embodiments are not limited to the embodiments described above but may vary within the scope of the claims.

## Claims

1. A system comprising a surge arrester (22, 31, 32) and an airfield lighting system, wherein
the airfield lighting system comprises a primary circuit having multiple of transformers (24, 25) with primary windings and secondary windings, the primary windings of the transformers being connected in series in the primary circuit and at least one of the secondary windings of the transformers being adapted to feed electric power to a secondary circuit having an illumination device (21) of the airfield lighting system,
wherein the surge arrester (22, 31, 32) is configured to provide a low impedance current path to ground for excessive voltages; **characterized in that** the surge arrester comprises a hermetically sealed enclosure for protecting a circuitry of the surge arrester;
connectors (J1,J2,J4,J5) configured to electrically connect the surge arrester to the secondary circuit, wherein the connectors (J1,J2,J4,J5) are configured to associated mating connectors on the secondary circuit of the airfield lightning system and one of the connectors (J3) is configured to connect to a ground (GND), and
wherein the surge arrester is adapted to protect the transformer and the primary circuit for excessive voltages that are applied to the illumination device or to a circuitry of the illumination device;
wherein the surge arrester is a stand-alone unit that is configured to be attachable and installable to an existing airfield lightning system; and
wherein the enclosure of the surge arrester is configured such that when the connectors are connected to the mating connectors, an outer material of the enclosure of the surge arrester extends over the point of connection.

2. The system according to claim 1, wherein the connectors are in a form of standardized connectors enabling the surge arrester to be attached to a standard installation of the airfield lightning system.

3. The system according to claim 1, wherein the secondary circuit comprises further a lamp control module (23) connected at the input of the secondary circuit, wherein the surge arrester is adapted to protect the lamp control module by providing a low impedance current path for excessive voltages that are applied to the illumination device or to the circuitry of the illumination device.

4. The system according to any preceding claim, wherein the surge arrester comprises an electric circuit comprising multiple of gas discharge tubes (F1, F2, F3) mounted on a printed circuit board.

5. The system according to any preceding claim, wherein the electric circuit of the surge arrester provides a low impedance current path through the surge arrester for operating power of the illumination device.

6. The system according to any preceding claim, wherein the connectors comprise a pair of input terminals (J1, J4), a pair of output terminals (J2, J5) and a grounding terminal (J3), wherein the electric circuit comprises direct currents paths (J1, J2; J4, J5) between the respective input terminals and output terminals, and a series connection of gas discharge tubes (F1, F3) connected between the current paths, wherein a gas discharge tube (F2) is connected in parallel with the series connection of the gas discharge tubes (F1, F3), and wherein the grounding terminal is connected to the circuit at a point in between the series connection of gas discharge tubes (F1, F3).

7. The system according to any preceding claim, wherein the hermetically sealed enclosure comprises a low pressure molded inner structure enclosing the circuitry of the surge arrester and an outer structure enclosing inner structure and providing a hermetically sealed casing.

## Patentansprüche

1. System umfassend einen Überspannungsableiter (22, 31, 32) und ein Flugfeldbeleuchtungssystem, wobei
das Flugfeldbeleuchtungssystem einen Primärkreis umfasst, der mehrere Transformatoren (24, 25) mit Primärwicklungen und Sekundärwicklungen aufweist, wobei die Primärwicklungen der Transformatoren im Primärkreis in Reihe geschaltet sind und mindestens eine der Sekundärwicklungen der Transformatoren ausgelegt ist, einem Sekundärkreis, der eine Beleuchtungseinrichtung (21) des Flugfeldbeleuchtungssystems aufweist, elektrische Energie zuzuführen,
wobei der Überspannungsableiter (22, 31, 32) eingerichtet ist, für übermäßige Spannungen einen Strompfad mit niedriger Impedanz zur Masse bereitzustellen;
**dadurch gekennzeichnet, dass** der Überspannungsableiter eine hermetisch verschlossene Kammer zum Schutz einer Schaltung des Überspannungsableiters umfasst;
Verbinder (J1, J2, J4, J5), die eingerichtet sind, den Überspannungsableiter elektrisch mit dem Sekundärkreis zu verbinden, wobei die Verbinder (J1, J2, J4, J5) mit zugehörigen Gegenverbindern an dem Sekundärkreis des Flugfeldbeleuchtungssystems eingerichtet sind, und einer der Verbinder (J3) eingerichtet ist, sich mit einer Masse (GND) zu verbinden, und
wobei der Überspannungsableiter ausgelegt ist, den Transformator und den Primärkreis vor übermäßigen Spannungen, die an der Beleuchtungseinrichtung oder an einer Schaltung der Beleuchtungseinrichtung angelegt werden, zu schützen;
wobei der Überspannungsableiter eine eigenständige Einheit ist, die eingerichtet ist, an einem vorhandenen Flugfeldbeleuchtungssystem anbringbar und installierbar zu sein; und
wobei die Kammer des Überspannungsableiters so eingerichtet ist, dass, wenn die Verbinder mit den Gegenverbindern verbunden sind, ein Außenmaterial der Kammer des Überspannungsableiters sich über den Verbindungspunkt erstreckt.

2. System nach Anspruch 1, wobei die Verbinder in einer Form von genormten Verbindern ausgeführt sind, die es ermöglichen, den Überspannungsableiter an einer Standardinstallation des Flugfeldbeleuchtungssystems anzubringen.

3. System nach Anspruch 1, wobei der Sekundärkreis ferner ein Lampensteuerungsmodul (23) umfasst, das am Eingang des Sekundärkreises verbunden ist, wobei der Überspannungsableiter ausgelegt ist, das Lampensteuerungsmodul durch Bereitstellen eines Strompfads mit niedriger Impedanz vor übermäßigen Spannungen, die an der Beleuchtungseinrichtung oder an der Schaltung der Beleuchtungseinrichtung angelegt werden, zu schützen.

4. System nach einem der vorhergehenden Ansprüche, wobei der Überspannungsableiter einen elektrischen Schaltkreis umfasst, der mehrere Gasentladungsröhren (F1, F2, F3) umfasst, die auf einer gedruckten Leiterplatte befestigt sind.

5. System nach einem der vorhergehenden Ansprüche, wobei der elektrische Schaltkreis des Überspannungsableiters einen Strompfad mit niedriger Impedanz durch den Überspannungsableiter für die Betriebsleistung der Beleuchtungseinrichtung bereitstellt.

6. System nach einem der vorhergehenden Ansprüche, wobei die Verbinder ein Paar von Eingangsanschlüssen (J1, J4), ein Paar von Ausgangsanschlüssen (J2, J5) und einen Masseanschluss (J3) umfassen, wobei der elektrische Schaltkreis Gleichstrompfade (J1, J2; J4, J5) zwischen den jeweiligen Eingangsanschlüssen und Ausgangsanschlüssen und eine Reihenschaltung von Gasentladungsröhren (F1, F3), die zwischen die Strompfade geschaltet sind, umfasst, wobei eine Gasentladungsröhre (F2) parallel zu der Reihenschaltung der Gasentladungsröhren (F1, F3) geschaltet ist und wobei der Masseanschluss an einem Punkt zwischen der Reihenschaltung der Gasentladungsröhren (F1, F3) mit dem Schaltkreis verbunden ist.

7. System nach einem der vorhergehenden Ansprüche, wobei die hermetisch verschlossene Kammer eine unter Niederdruck geformte innere Struktur umfasst, die die Schaltung des Überspannungsableiters umschließt, und eine äußere Struktur, die die innere Struktur umschließt und ein hermetisch abgedichtetes Gehäuse bereitstellt.

## Revendications

1. Un système comprenant un parafoudre (22, 31, 32) et un système d'éclairage d'aérodrome,
dans lequel le système d'éclairage d'aérodrome comprend un circuit primaire comportant plusieurs transformateurs (24, 25) avec des enroulements primaires et secondaires, les enroulements primaires des transformateurs étant connectés en série dans le circuit primaire et au moins l'un des enroulements secondaires des transformateurs étant adapté pour alimenter en énergie électrique un circuit secondaire comportant un dispositif d'illumination (21) du système d'éclairage de l'aérodrome,
dans lequel le parafoudre (22, 31, 32) est configuré pour fournir un chemin de courant de faible impédance à la masse dans le cas de tensions excessives;
**caractérisé en ce que** le parafoudre comprend
une enceinte hermétiquement scellée pour protéger le circuit du parafoudre; des connecteurs (J1, J2, J4, J5) configurés pour connecter électriquement le parafoudre au circuit secondaire, dans lequel les connecteurs (J1, J2, J 4, J5) sont configurés pour des connecteurs d'accouplement associés sur le circuit secondaire du système d'éclairage de l'aérodrome, l'un des connecteurs (J3) étant configuré pour se connecter à une masse (GND), et
dans lequel le parafoudre est adapté pour protéger le transformateur et le circuit primaire de tensions excessives qui sont appliquées au dispositif d'illumination ou à un circuit du dispositif d'illumination;
dans lequel le parafoudre est une unité autonome qui est configurée pour pouvoir être fixée et installée sur un système d'éclairage d'aérodrome existant; et
dans lequel l'enceinte du parafoudre est configurée de telle sorte que lorsque les connecteurs sont connectés aux connecteurs d'accouplement, un matériau extérieur de l'enceinte du parafoudre s'étend sur le point de connexion.

2. Le système selon la revendication 1, dans lequel les connecteurs sont sous forme de connecteurs normalisés permettant de fixer le parafoudre à une installation standard du système d'éclairage de l'aérodrome.

3. Le système selon la revendication 1, dans lequel le circuit secondaire comprend en outre un module de commande de lampe (23) connecté à l'entrée du circuit secondaire, dans lequel le parafoudre est adapté pour protéger le module de commande de lampe en présentant un chemin de courant à faible impédance pour des tensions excessives qui sont appliquées au dispositif d'illumination ou aux circuits du dispositif d'illumination.

4. Le système selon l'une quelconque des revendications précédentes, dans lequel le parafoudre comprend un circuit électrique comprenant plusieurs tubes à décharge de gaz (FI, F2, F3) montés sur une carte de circuit imprimé.

5. Le système selon l'une quelconque des revendications précédentes, dans lequel le circuit électrique du parafoudre fournit un chemin de courant à faible impédance à travers le parafoudre pour l'énergie de fonctionnement du dispositif d'illumination.

6. Le système selon l'une quelconque des revendications précédentes, dans lequel les connecteurs comprennent une paire de bornes d'entrée (J1, J4), une paire de borne de sortie (J2, J5) et une borne de mise à la masse (J3), dans lequel le circuit électrique comprend des trajets de courants directs (J1, J2; J4, J5) entre les bornes d'entrée et de sortie respectives, et une connexion en série de tubes à décharge de gaz (F1, F3) connectés entre les trajets de courant, dans lequel un tube à décharge de gaz (F2) est connecté en parallèle avec la connexion en série des tubes à décharge de gaz (F1, F3), et dans lequel la borne de mise à la masse est connectée au circuit en un point situé entre la connexion en série des tubes à décharge de gaz (F1, F3).

7. Le système selon l'une quelconque des revendications précédentes, dans lequel l'enceinte hermétiquement scellée comprend une structure intérieure moulée à basse pression enfermant le circuit du parafoudre et une structure extérieure enfermant la structure intérieure et fournissant une enveloppe hermétiquement scellée.
